Europäisches Patentamt

European Patent Office

Office européen des brevets

(11) Veröffentlichungsnummer: **0 293 544**
**A1**

## (12) EUROPÄISCHE PATENTANMELDUNG

(21) Anmeldenummer: 88101349.4

(22) Anmeldetag: 30.01.88

(51) Int. Cl.⁴: **C08G 59/40** , **C08J 5/24**

(30) Priorität: 06.05.87 DE 3714997

(43) Veröffentlichungstag der Anmeldung:
07.12.88 Patentblatt 88/49

(84) Benannte Vertragsstaaten:
AT CH DE ES GB IT LI

(71) Anmelder: AEG ISOLIER- UND KUNSTSTOFF GMBH
Otto-Hahn-Strasse 5
D-3500 Kassel(DE)

(72) Erfinder: Schäfer, Hans-Jürgen
Hessenring 56
D-3502 Vellmar(DE)

(74) Vertreter: Lertes, Kurt, Dr. et al
AEG Aktiengesellschaft Theodor-Stern-Kai 1
D-6000 Frankfurt/Main 70(DE)

(54) Epoxidharzformulierung mit extrem kurzer Härtungszeit.

(57) Härterkombination mit einem Imidazol für ein Epoxidharz zur kontinuierlichen Herstellung von kupferkaschiertem Basismaterial für Leiterplatten in einer Doppelbandpresse. Um einen Härter für kurze Härtungszeiten ohne Qualitätsminderung des Laminats verfügbar zu machen, besteht die Härterkombination aus 2-Methylimidazol und Cyanid.

EP 0 293 544 A1

## Epoxidharzformulierung mit extrem kurzer Härtungszeit zur Herstellung von Epoxidglaslaminaten auf kontinuierlich arbeitenden Doppelbandpressen.

Epoxidglaslaminate werden in der Dicken von 0,1 - 3,2 mm ein- und beidseitig mit Kupferfolie kaschiert zur Herstellung von Leiterplatten bzw. gedruckten Schaltungen verwendet.

Zur Herstellung dieser Laminate werden Glasgewebe wie z. B. US Style 7628 mit 200 g/m² Flächengewicht mit 40 bis 45 % Epoxidharz beharzt. Dies geschieht üblicherweise durch Imprägnieren des Glasgwebes mit einer entsprechenden Harzlösung und durch Trocknen des sogenannten Prepregs auf einen definierten Vorhärtungsgrad.

Diese Prepregs werden geschnitten, übereinander geschichtet und mit Kupferfolie zwischen Edelstahlblechen in Mehrlagenpressen unter Druck und Temperatur ausgehärtet.

Übliche Harze sind z. B. bromierte Epoxidharze auf Bisphenol-A-Basis.

|        | Epoxid-äquivalent | Bromgehalt |
|--------|-------------------|------------|
| Harz A | 460 - 510         | 18 - 22    |
| Harz B | 500 - 530         | 21 - 23    |
| Harz C | 665 - 725         | 24 - 26    |

Diese Harze werden normalerweise mit Dicyandiamid $H_2N-C-NH-C\equiv N$ ($C_2H_4N_4$) gehärtet. Die Härtermengen betragen 3 bis 3,5 % bezogen auf Festharz.

Als Beschleuniger bzw. Katalysatoren werden N-Benzyldimethylamin (BDMA), N.N.N.N Tetramethyl-1.3 Butandiamin (TMBDA) sowie 2-Methyl Imidazol (2MI) eingesetzt.

Beispiel 1:

125 Tl Epoxidharz EW 450 (80 %)
3 Tl Dicyandiamid
0,2 Tl BDMA
B-Zeit 240 s bei 170 °C

Beispiel 2:

125 Tl Epoxidharz EW 450 (80 %)
3,5 Tl Dicyandiamid
0,2 Tl BDMA
B-Zeit 200 s bei 170 °C

Aus dem Vergleich der Härtungszeiten ist zu erkennen, daß der Anteil des Dicyandiamides bei gleichbleibender Beschleunigermenge einen starken Einfluß auf die Reaktionszeit hat. Der Härter Dicyandiamid ist jedoch zu schwer löslich. Es wird daher von Fachleute empfohlen, nicht mehr als 3,5 Teile einzusetzen. Bei höhren Konzentrationen wird die Laminateigenschaft, insbesondere die Feuchtigkeitsstabilität verschlechtert. Eine Verschlechterung der Laminateigenschaften tritt außerdem bei Erhöhung des Beschleunigeranteiles BDMA ein.

## LÖTBADSTABILITÄT (260 °C)

### Lötbadfestigkeit in Sekunden

| LZ 8011 N-80 P.B.W. | 125 | | | | | | | | |
| HZ 986 R-10 P.B.W. | 30 | | | 35 | | | 40 | | |
| DY 062 P.B.W. | 0,2 | 0,4 | 0,8 | 0,2 | 0,4 | 0,8 | 0,2 | 0,4 | 0,8 |
|---|---|---|---|---|---|---|---|---|---|
| Anfangswert | | > 600 | 30 | | 50 | 18 | | 50 | 28 |
| nach 1 h H$_2$O/100 °C | | 60 | 15 | > 600 | 35 | > 10 | > 600 | 16 | 15 |
| nach 2 h H$_2$O/100 °C | > 600 | 25 | < 10 | | 30 | 26 | 15 | < 10 | < 10 |
| nach 3 h H$_2$O/100 °C | 35 | 20 | | | 25 | 21 | < 10 | | |
| nach 4 h H$_2$O/100 °C | 25 | 14 | | | 20 | 16 | | | |
| nach 5 h H$_2$O/100 °C | < 10 | < 10 | | | < 10 | < 10 | | | |

Untersuchung Ciba Geigy

HZ 986 R-10 = Dicyandiamid 10 %
DY 062 = Benzyldimethylamin (BDMA)

Der Erfindung liegt daher die Aufgabe zugrunde, eine Harzformulierung zu finden, mit der es möglich ist, Härtungszeiten von 1 min bei 190 °C bei 95 %iger Aushärtung zu realisieren, und die beschriebenen negativen Qualitätsmerkmale zu umgehen. Um dies zu erreichen, mußte zunächst ein Beschleuniger eingesetzt werden, der die bei BDMA beschriebenen Nachteile nicht aufweist. Dies konnte überraschenderweise mit dem 2-Methyl-Imidazol erreicht werden.

Es hat sich gezeigt, daß 2MI gegenüber 2,4 Methylimidazol eine um 30 % höhere Härtungsgeschwindigkeit und gegenüber BDMA eine um 200 % höhere Härtungsgeschwindigkeit aufweist.

Da das Dicyandiamid die Laminateigenschaften bei höherer Konzentration verschlechtert, mußte ein neuer Härter gefunden werden. Dieser ist in dem Vorprodukt von Dicyandiamid gefunden worden. Man hat herausgefunden, daß Cyanamid $\overset{H}{\underset{H}{}} \diagup \! \diagdown N\text{-}C\text{≡}N$ als Härter für Epoxidglaslaminate mit kurzer Härtungszeit eingesetzt werden kann. Dieser Härter ist löslich in Wasser, Alkoholen und Ketonen. Er hat somit den Vorteil, daß nicht wie bei Dicyandiamid mit Hochsiedern wie z. B. Methylglykol bzw. Dimethylformamid gearbeitet werden muß.

Dies ist insbesondere in Bezug auf den Restlösemittelanteil bei extrem kurzen Reaktionszeiten von ausschlaggebender Bedeutung.

Beispiel 1:

125 Tl Epoxidharz 80 %
3,752 Tl Dicyandiamid
0,4 Tl 2MI

Beispiel 2:

125 Tl Epoxidharz 80 %
3,75 Tl Cyanamid
0,4 Tl 2MI

EP 0 293 544 A1

Reaktionszeit bei 95 % Aushärtung:

|  | Beispiel 1 | Beispiel 2 |
|---|---|---|
| 100 °C | 315 min | 500 min |
| 150 °C | 11 min | 12 min |
| 180 °C | 2 min | 2 min |
| 190 °C | 1,2 min | 1 min |
| 200 °C | 0,8 min | 0,6 min |

Vergleich der Lötbadfestigkeit nach Belastung im Heißdampf 2 bar (120 °C):

| Beispiel 1 | Beispiel 2 |
|---|---|
| 2 Stunden | 4 Stunden |
| 20 s Lötbad | 20 s Lötbad |

Als besonders vorteilhaft hat sich ein Harzsystem herausgestellt, welches mehr als 50 % niedermolekulare Anteile aufweist. $n_0 + n_2 \geq 50\%$

Es hat sich somit überraschenderweise herausgestellt, daß es mit der erfindungsgemäßen Harz/Härter/Beschleuniger-Kombination gelungen ist, ein System für die kontinuierliche Produktion von Epoxidglaslaminaten zur Verfügung zu stellen, welches bei kürzesten Härtungszeiten nicht mit dem nach dem Stand der Technik üblichen negativen Qualitätsmerkmalen behaftet ist.

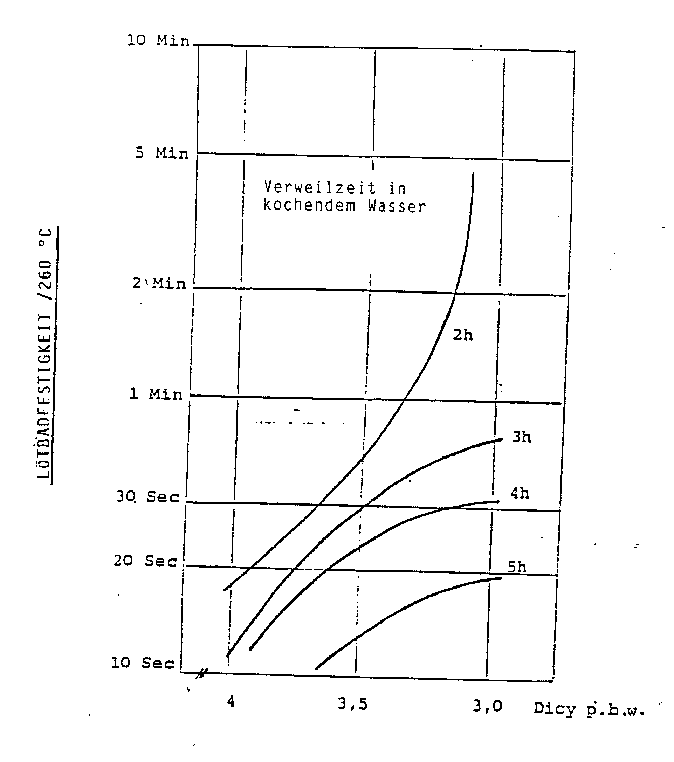

**Ansprüche**

1. Epoxidharzhärtersystem für kontinuierliches Pressen dadurch gekennzeichnet, daß der Härter Cyanamid in Verbindung mit 2 Methylimidazol zum Härten von Epoxidharzen eingesetzt wird.

2. Epoxidharzhärtersystem für kontinuierliches Pressen dadurch gekennzeichnet, daß das Epoxidharz ein Epoxidäquivalent von 300 bis 400 hat.

3. Epoxidharzhärtersystem für kontinuierliches Pressen dadurch gekennzeichnet, daß als Beschleuniger 2,4 Methylimidazol in Verbindung mit Cyanamid eingesetzt wird.

4. Epoxidharzhärtersystem für kontinuierliches Pressen dadurch gekennzeichnet, daß keine Lösungsmittel mit einem Siedepunkt > 80 °C eingesetzt werden.

5. Epoxidharzhärtersystem für kontinuierliches Pressen dadurch gekennzeichnet, daß die Reaktionszeit (B-Zeit) bei 170 °C 30 bis 80 s beträgt.

6. Epoxidharzhärtersystem für kontinuierliches Pressen dadurch gekennzeichnet, daß der Feststoffanteil der Harzlösung $\geq$ 65 % beträgt.

7. Epoxidharzhärtersystem für kontinuierliches Pressen dadurch gekennzeichnet, daß der Härter Cyanamid im Harz gelöst wird und somit eine lösungsmittelfreie Imprägnierung ermöglicht.

8. Epoxidharzhärtersystem für kontinuierliches Pressen dadurch gekennzeichnet, daß der Cyanamidgehalt 2 bis 6 % beträgt.

9. Epoxidharzhärtersystem für kontinuierliches Pressen dadurch gekennzeichnet, daß der 2 Methylimidazolgehalt 0,1 bis 0,8 % beträgt.

4

LÖTBADFESTIGKEIT /260 °C

10 Min

5 Min

Verweilzeit in
kochendem Wasser

2 Min

2h

1 Min

3h

30 Sec

4h

20 Sec

5h

10 Sec

4          3,5          3,0        Dicy p.b.w.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | FR-A-2 137 651 (SCHERING)<br>* Ansprüche; Seite 3, Zeilen 27-28 *<br>----- | 1 | C 08 G 59/40<br>C 08 J 5/24 |

**RECHERCHIERTE SACHGEBIETE (Int. Cl.4)**

C 08 G

Der vorliegende Recherchenbericht wurde für alle Patentansprüche erstellt

| Recherchenort | Abschlußdatum der Recherche | Prüfer |
|---|---|---|
| DEN HAAG | 29-08-1988 | DERAEDT G. |